# EUROPEAN PATENT SPECIFICATION

(11) **EP 2 258 655 B1**
(45) Date of publication and mention of the grant of the patent: **25.04.2012**
(21) Application number: 09161994.0
(22) Date of filing: 05.06.2009
(51) Int. Cl.: B81C 1/00

(54) **A method for producing a microstructure of crystalline SiC**
Verfahren zur Herstellung einer Mikrostruktur von kristallinem SiC
Procédé de production d'une microstructure de SiC cristallin

(43) Date of publication of application: 08.12.2010
(73) Proprietor: Acreo AB, 164 40 Kista (SE)
(72) Inventor: Schöner, Adolf, 165 74, HÄSSELBY (SE); Vieider, Christian, 752 36, UPPSALA (SE)
(74) Representative: Haag, Malina Anna

(56) References cited:
- WO-A-01/56069
- US-A1- 2006 027 884
- SARRO P M: "Silicon carbide as a new MEMS technology" SENSORS AND ACTUATORS A, ELSEVIER SEQUOIA S.A., LAUSANNE, CH, vol. 82, no. 1-3, 1 May 2000 (2000-05-01), pages 210-218, XP004198264 ISSN: 0924-4247
- PAKULA L S ET AL: "Fabrication of a CMOS compatible pressure sensor for harsh environments; Fabrication of a CMOS compatible pressure sensor for harsh environments" JOURNAL OF MICROMECHANICS & MICROENGINEERING, INSTITUTE OF PHYSICS PUBLISHING, BRISTOL, GB, vol. 14, no. 11, 1 November 2004 (2004-11-01), pages 1478-1483, XP020069570 ISSN: 0960-1317

## Description

### FIELD OF THE INVENTION

The present invention relates to a method for producing a microstructure of crystalline SiC having at least one gap between structural parts thereof.

"Crystalline" does here mean a well ordered structure being at least nearly mono-crystalline.

The presence of a said gap between structural parts of the microstructure means that the microstructure has a diaphragm, a cantilever (beam) or similar structural element built in into the microstructure. Such a microstructure is primarily suitable for being used in different types of microelectromechanical devices in the form of sensors, where the possibility of said diaphragm or cantilever to move with respect to other parts of the microstructure by influence of pressure, acceleration and other parameters to be measured may be utilized. Methods for producing such microstructures for microelectromechanical devices used as such sensors are well developed for Si. However, such microelectromechanical devices are not suitable for use in harsh environments including locations of high temperature, high vibrational frequency, high wear and those containing corrosive media. In contrast, such microstructures of crystalline SiC would be well adapted to function well under such conditions, since silicon carbide has exactly the properties then asked for. Thus, it would then be possible to benefit from the superior properties of SiC in the form of high temperature stability, high mechanical strength and so on well known within the literature. However, exactly these physical properties of SiC make it impossible to utilize the techniques developed for producing microstructures of Si for producing similar structures of crystalline SiC.

### BACKGROUND ART

A number of methods have so far been proposed for producing a microstructure of crystalline SiC having at least one gap between structural parts thereof. These methods all suffer from different types of drawbacks.

One known method involves etching of a bulk material of crystalline SiC for trying to form said gap. This is difficult on one hand because the high resistance of SiC to etch chemicals and on the other since any type of layer that stops the etching is required, for instance any type of selective doping for using electrochemical etching.

An alternative method involves etching of structures on two different substrates of crystalline SiC and then bonding these substrates to each other for forming a gap therebetween. However, it is difficult to obtain a good surface quality in SiC, so that it has so far been necessary to involve "softer" intermediate layers of another material than SiC, which is no attractive option and for some types of microelectromechanical devices aimed at not acceptable.

A further known method utilizes depositing, such as by Chemical Vapour Deposition (CVD), of SiC onto a thin sacrificial layer of oxide, which is then etched away in a further step. However, the temperature for the deposition process is restricted by the oxide, which gets instable above about 1000°C, which results in an inferior quality of the polycrystalline SiC. This type of method is known through for instance the article "Micro- and nanomechanical structures for silicon carbide MEMS and NEMS" by Zorman and Parro in phys.stat.sol. (b) 245, No. 7, 1404-1424 (2008) in which it is described how amorphous SiC is deposited onto a polymerous sacrificial layer, which then results in a microe!ectromechanical device having amorphous SiC as a part, which is not aimed at by the present invention.

WO 01/56069 A discloses a method for producing a microstructure of crystalline SiC having at least one gap between structural parts thereof of the type defined in the preamble of appended claim 1. Said first crystalline layer of a material able to form a crystalline structure on crystalline SiC grown onto the substrate of crystalline SiC and later forming a sacrificial layer is in that method of SiC. Selective etching of SiC is then used for removing said first layer of SiC. Such selective etching uses variations of the nature of doping and the positions of doped regions in the different layers of SiC for etching away only said first layer but not said second layer or the substrate.

### SUMMARY OF THE INVENTION

It is an object of the present invention to provide an alternative method for producing a microstructure of crystalline SiC having at least one gap between structural parts thereof being improved in at least some aspect with respect to such methods already known.

This is according to the present invention obtained by growing said first layer of Si or GaN. It has turned out that a sacrificial layer which may easily be etched away in step d) may in this way be grown as said first crystalline layer in step a) and then form a crystalline structure on crystalline SiC of said substrate. Crystalline Si has turned out to be well suited for such a sacrificial layer, especially if a layer of crystalline SiC of the polytype 3C is epitaxially grown on top thereof, since this may be accomplished at such high temperatures, such as up to 1400°C, which are desired for obtaining a perfect order and high quality of said crystalline SiC layer. Another possible material to be used for the sacrificial layer is GaN, which can stand even higher temperatures and is compatible with other SiC polytypes, such as 4H and 6H.

Accordingly, it has surprisingly been found that crystalline Si or GaN may be used as a sacrificial layer between a substrate of crystalline SiC and a second layer of crystalline SiC, and these materials are easy to etch away exactly by the fact that they are of another material than SiC, so that no particular doping is required for obtaining selective etching.

According to another embodiment of the invention the method comprises a further step carried out after step a) and before step b) of removing, such as by etching, peripheral portions of said first layer formed in step a) for defining a region of restricted lateral extension of said first layer upon said substrate so as to define the lateral extension of said gap subsequently formed in step d). The lateral extension of said gap may by this method step be well defined by simple means. In the case of using Si as the material for the sacrificial layer such removal by etching may be easily carried out.

According to another embodiment of the invention said further step is carried out by applying a mask over a region of said first layer having said restricted lateral extension and etching away portions of said first layer not covered by said mask.

According to another embodiment of the invention step c) is carried out by etching, such as lithographic etching, through said second layer, so that the sacrificial layer may then in step e) efficiently be removed through said opening for forming said gap.

According to another embodiment of the invention the method comprises a step e) carried out after step d) of epitaxially growing a third layer of crystalline SiC onto said second layer for covering said opening and forming said gap in the form of a closed cavity. A microstructure entirely of crystalline SiC having a closed cavity may in this way easily be obtained. One advantageous use of such a microstructure is in a microelectromechanical device used to measure static pressures.

According to another embodiment of the invention constituting a further development of the embodiment last mentioned the method comprises a step f) carried out after step d) and before or after step e) of creating a channel-like opening with a lateral extension through said second layer establishing a path between said gap and the exterior of the structure. This means that a microstructure well suited for measuring dynamic pressures, i.e. pressure variations, is obtained, and SiC is a very preferred material for such a sensor, since the Young's modulus of SiC is approximately three times higher than for Si, so that the upper frequency limit for registration of such variations is considerably higher for SiC than for Si.

According to another embodiment of the invention it is a microstructure of crystalline SiC of the polytype 3C that is produced. It has turned out that this polytype is especially preferred for obtaining a high quality crystalline structure of SiC by a method according to the present invention, and this polytype has to be used when Si is used as sacrificial layer.

According to another embodiment of the invention the height of said gap is defined by growing a first layer with a thickness of 0.2-5 µm, especially 0.5-2 µm in step a), which results in a gap with suitable dimensions for microelectromechanical devices of crystalline SiC.

According to another embodiment of the invention said first layer is in step a) grown onto a substrate of crystalline SiC, which in its turn previously has been grown on a layer of crystalline Si which may then be utilized for instance as a holding fixture for an optical fibre connected to the SiC microstructure used as a sensor in a fibre optical system, such as for pressure measurement.

Further advantages as well as advantageous features of the invention will appear from the following description.

### BRIEF DESCRIPTION OF THE DRAWING

With reference to the appended drawing, below follows a specific description of embodiments of the invention cited as examples.

In the drawings:
- Figs 1-5: are very schematical views illustrating different steps in a method for producing a microstructure of crystal- line SiC according to an embodiment of the invention,
- Fig 6: is a simplified view of a microelectromechanical de- vice according to an embodiment of the present in- vention, and
- Fig 7: is a view similar to that of Fig 5 of a microstructure of crystalline SiC produced through a method according to another embodiment of the invention.

### DETAILED DESCRIPTION OF EMBODIMENTS OF THE INVENTION

It is first of all pointed out that the Figures on the appended drawing are not drawn at scale, but are only used to explain the different steps of methods for producing a microstructure of crystalline SiC according to the present invention as well as the structure of microelectromechanical devices according to the invention.

A method according to an embodiment of the present invention starts with a substrate 1 of mono-crystalline SiC, here of the polytype 3C. This layer may have any conceivable doping concentration of n-type and/or p-type or be intrinsic. It has preferably been produced by Chemical Vapour Deposition by known means, such as by cracking of silane and propane heated to a temperature in the order of 1300°C-2000°C. The thickness of the substrate layer may also be any suitable for the intended use of the microstructure to be produced in this way.

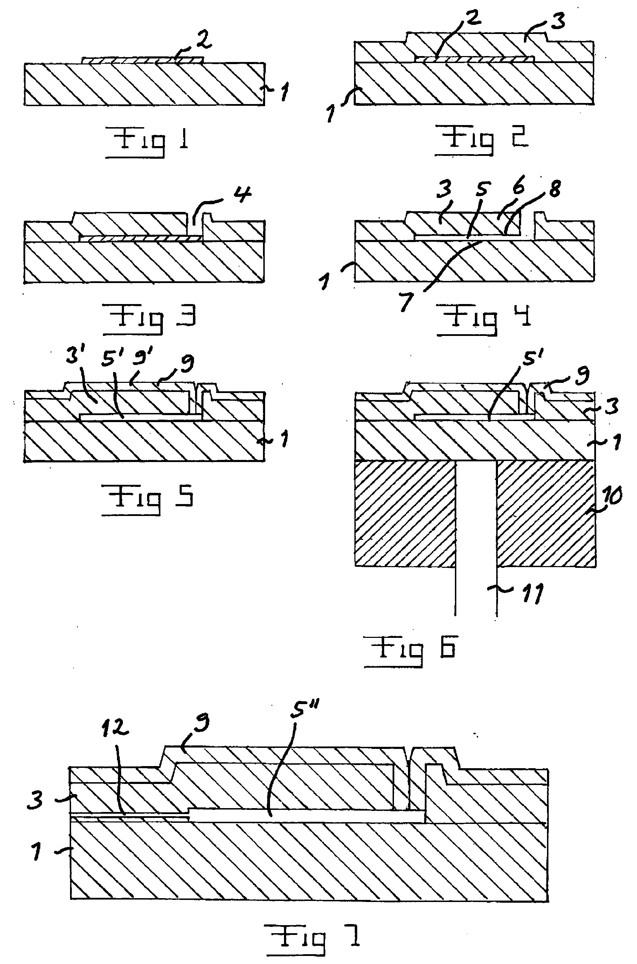

A first mono-crystalline layer 2 of Si with a thickness of 0.2-5 µm, here in the order of 1 µm, is epitaxially grown onto the substrate 1. A patterned mask is then applied onto said first layer 2 and a lithographic etch is carried out for removing peripheral portions of the first layer for defining a region of restricted lateral extension of this first layer, as shown in Fig 1.

A second layer 3 of mono-crystalline SiC is then epitaxially grown on top of the first layer 2 and outside the lateral extension thereof then also on the substrate 1 as shown in Fig 2. This step is followed by a step of creating an opening 4 through the second layer 3 to the first layer 2 as shown in Fig 3. This may be done by lithographic etching. Said first layer 2, thus forming a sacrificial layer, is then etched away through the opening 4 for forming a gap 5 between the second layer 3 and the substrate of crystalline SiC 1.

It is well possible to stop the method here and utilize the microstructure according to Fig 4 in a microelectromechanical device by utilizing the cantilever or beam 6 so formed for measuring for instance accelerations or dynamic pressures by measuring the movement of this cantilever 6 with respect to the rest of the microstructure. Such measurements may be carried out for instance by measuring the distance between opposing surfaces 7, 8 of said gap 5 or by piezo-electricity or by piezo resistance measurement.

However, the method may comprise a further step of epitaxially growing a third layer 9 of mono-crystalline SiC onto said second layer 3 for covering the opening 4 and forming said gap 5' in the form of a closed cavity. This results in a microstructure shown in Fig 5, which is especially suited to be used in a pressure sensor for measuring static pressures, in which the parts 3' and 9' of the second and third layers, respectively, covering the gap 5' together form a diaphragm movable with respect to the substrate 1. Such a microelectromechanical device may then be based on measurements of the distance between the surface 7 of the substrate and the surface 8 of that diaphragm, such as by optical means.

Fig 6 illustrates schematically how such a microelectromechanical device used in a fibre optical system may be designed, in which it is shown how the substrate 1 has been previously grown on a layer 10 of crystalline Si, which is here used as a holding fixture for an optical fibre 11 connected to the microstructure of SiC.

The final step of a method according to a further embodiment of the invention is illustrated in Fig 7, which is carried out on a structure shown in Fig 5 by creating a channel-like opening 12 with a lateral extension through the second layer 3 establishing a path between the gap 5" and the exterior of the structure. The microstructure so obtained is perfectly designed for measuring very fast pressure variations in a medium surrounding said microstructure.

The invention is of course not in any way restricted to the embodiments described above, but many possibilities to modifications thereof will be apparent to a person with skill in the art without departing from the scope of the invention as defined in the appended claims.

The relative dimensions and shapes of the different parts of the microstructures shown in the Figures may be arbitrary and differing a lot with respect to these figures.

"Substrate" only means that this layer forms a substrate for growing said first layer thereupon, and this substrate may in its turn be a layer which has previously been grown onto another layer, as may be the case for producing the microstructure shown in Fig 6.

The third layer covering the opening may be of another material than crystalline SiC, such as a poly-crystalline or amorphous film of SiC or even of another material, such as SiO₂ depending upon under which conditions the microstructure is to be used later on.

## Claims

1. A method for producing a microstructure of crystalline SiC having at least one gap (5, 5', 5") between structural parts thereof, said method comprising the following steps:
a) a first crystalline layer (2) of a material able to form a crystalline structure on crystalline SiC is epitaxially grown onto a substrate (1) of crystalline SiC,
b) a second layer (3) of crystalline SiC is epitaxially grown on top of said first layer,
c) an opening (4) is made through said second layer to said first layer, and
d) said first layer (2), thus forming a sacrificial layer, is etched away through said opening for forming a said gap (5, 5', 5") between said second layer and substrate of crystalline SiC,
**characterized in that** it is Si that is grown as said first layer (2) in step a), or **in that** it is GaN that is grown as said first layer (2) in step a).

2. A method according to claim 1, **characterized in that** it comprises a further step carried out after step a) and before step b) of removing, such as by etching, peripheral portions of said first layer (2) formed in steps a) for defining a region of restricted lateral extension of said first layer upon said substrate (1) so as to define the lateral extension of said gap subsequently formed in step d).

3. A method according to claim 2, **characterized in that** said further step is carried out by applying a mask over a region of said first layer (2) having said restricted lateral extension and etching away portions of said first layer not covered by said mask.

4. A method according to any of the preceding claims, **characterized in that** step c) is carried out by etching, such as lithographic etching, through said second layer (3).

5. A method according to any of the preceding claims, **characterized in that** it comprises a step e) carried out after step d) of epitaxially growing a third layer (9) of crystalline SiC onto said second layer (3) for covering said opening (4) and forming said gap (5') in the form of a closed cavity.

6. A method according to claim 5, **characterized in that** it comprises a step f) carried out after step d) and before or after step e) of creating a channel-like opening (12) with a lateral extension through said second layer (3) establishing a path between said gap (5") and the exterior of the structure.

7. A method according to claim 1, **characterized in that** it is Si that is grown as said first layer (2) in step a), and **in that** it is a microstructure of crystalline SiC of the polytype 3C that is produced.

8. A method according to any of the preceding claims, **characterized in that** the height of said gap (5, 5', 5") is defined by growing a said first layer (2) with a thickness of 0.2-5 µm, especially 0.5-2 µm, in step a).

9. A method according to any of the preceding claims, **characterized in that** said first layer (2) is in step a) grown onto a substrate (1) of crystalline SiC, which in its turn previously has been grown on a layer (10) of crystalline Si.

## Patentansprüche

1. Verfahren zur Herstellung einer Mikrostruktur von kristallinem SiC, das mindestens eine Lücke (5, 5', 5") zwischen strukturellen Teilen davon aufweist, wobei das Verfahren folgende Schritte umfasst:
a) eine erste kristalline Schicht (2) aus einem Material, das dazu fähig ist, eine kristalline Struktur auf kristallinem SiC zu bilden, wird epitaxial auf ein Substrat (1) aus kristallinem SiC aufgezüchtet,
b) eine zweite Schicht (3) aus kristallinem SiC wird epitaxial auf der ersten Schicht gezüchtet,
c) eine Öffnung (4) wird durch die zweite Schicht zur ersten Schicht gebildet und
d) die erste Schicht (2), die so eine Opferschicht bildet, wird durch die Öffnung weggeätzt, um eine Lücke (5, 5', 5") zwischen der zweiten Schicht und dem Substrat aus kristallinem SiC zu bilden, **dadurch gekennzeichnet, dass** es Si ist, das als die erste Schicht (2) in Schritt a) gezüchtet wird oder dass es GaN ist, das als die erste Schicht (2) in Schritt a) gezüchtet wird.

2. Verfahren nach Anspruch 1, **dadurch gekennzeichnet, dass** es einen weiteren Schritt umfasst, der nach Schritt a) und vor Schritt b) durchgeführt wird, des Entfernens , wie beispielsweise durch Ätzen, peripherer Anteile der ersten Schicht (2), die in den Schritten a) gebildet wird, um einen Bereich beschränkter lateraler Erweiterung der ersten Schicht auf dem Substrat (1) zu definieren, um die laterale Erweiterung der Lücke, die daraufhin in Schritt d) gebildet wird, zu definieren.

3. Verfahren nach Anspruch 2, **dadurch gekennzeichnet, dass** der weitere Schritt durch Aufbringen einer Maske über einen Bereich der ersten Schicht (2), der eine beschränkte laterale Erweiterung aufweist, und Wegätzen von Anteilen der ersten, nicht durch die Maske bedeckten Schicht durchgeführt wird.

4. Verfahren nach einem der vorhergehenden Ansprüche, **dadurch gekennzeichnet, dass** Schritt c) durch Ätzen, wie beispielsweise lithographisches Ätzen, durch die zweite Schicht (3) durchgeführt wird.

5. Verfahren nach einem der vorhergehenden Ansprüche, **dadurch gekennzeichnet, dass** es einen Schritt e) umfasst, der nach Schritt d) durchgeführt wird, des epitaxialen Aufzüchtens einer dritten Schicht (9) aus kristallinem SiC auf die zweite Schicht (3) zum Bedecken der Öffnung (4) und Bilden der Lücke (5') in Form eines geschlossenen Hohlraums.

6. Verfahren nach Anspruch 5, **dadurch gekennzeichnet, dass** es einen Schritt f) umfasst, der nach Schritt d) und vor oder nach Schritt e) durchgeführt wird, des Schaffens einer kanalähnlichen Öffnung (12) mit einer lateralen Erweiterung durch die zweite Schicht (3) unter Einrichten eines Wegs zwischen der Lücke (5") und dem Äußeren der Struktur.

7. Verfahren nach Anspruch 1 **dadurch gekennzeichnet, dass** es Si ist, das als die erste Schicht (2) in Schritt a) gezüchtet wird und dass es eine Mikrostruktur von kristallinem SiC des Polytyps 3C ist, die hergestellt wird.

8. Verfahren nach einem der vorhergehenden Ansprüche, **dadurch gekennzeichnet, dass** die Höhe der Lücke (5, 5', 5") durch Züchten einer ersten Schicht (2) mit einer Dicke von 0,2-5 µm, insbesondere 0,5-2 µm, in Schritt a) definiert wird.

9. Verfahren nach einem der vorhergehenden Ansprüche, **dadurch gekennzeichnet , dass** die erste Schicht (2) in Schritt a) auf ein Substrat (1) aus kristallinem SiC aufgezüchtet wird, das wiederum vorher auf einer Schicht (10) von kritsallinem Si gezüchtet worden ist.

## Revendications

1. Procédé de production d'une microstructure de SiC cristallin ayant au moins un interstice (5, 5', 5") entre ses parties structurelles, ledit procédé comprenant les étapes suivantes :
a) une première couche cristalline (2) d'un matériau cabale de former une structure cristalline sur le SiC cristallin est formée par croissance épitaxiale sur un substrat (1) de SiC cristallin,
b) une deuxième couche (3) de SiC cristallin est formée par croissance épitaxiale au-dessus de ladite première couche,
c) une couverture (4) est faite à travers ladite deuxième couche jusqu'à ladite première couche, et
d) ladite première couche (2), formant ainsi une couche sacrificielle, est éliminée par gravure par ladite ouverture pour former ledit interstice (5, 5', 5") entre ladite deuxième couche et le substrat de SiC cristallin, **caractérisé en ce que** c'est le Si qui est formé en tant que ladite première couche (2) dans l'étape a) ou **en ce que** c'est du GaN qui est formé en tant que ladite première couche (2) dans l'étape a).

2. Procédé selon la revendication 1, **caractérisé en ce qu'**il comprend une étape supplémentaire réalisée après l'étape a) et avant l'étape b) d'élimination, telle que par gravure, des parties périphériques de ladite première couche (2) formée dans l'étape a) pour définir une région d'extension latérale limitée de ladite première couche sur ledit substrat (1) de sorte à définir l'extension latérale dudit interstice formé ensuite dans l'étape d).

3. Procédé selon la revendication 2, **caractérisé en ce que** ladite étape supplémentaire est réalisée par l'application d'un masque sur une région de ladite première couche (2) comprenant ladite extension latérale limitée et l'élimination par gravure des parties de ladite première couche non recouvertes par ledit masque.

4. Procédé selon l'une quelconque des revendications précédentes, **caractérisé en ce que** l'étape c) est réalisée par gravure, telle qu'une gravure lithographique, à travers ladite deuxième couche (3).

5. Procédé selon l'une quelconque des revendications précédentes, **caractérisé en ce qu'**il comprend une étape e), réalisée après l'étape d), de croissance épitaxiale d'une troisième couche (9) de SiC cristallin sur ladite deuxième couche (3) pour recouvrir ladite ouverture (4) et former ledit interstice (5') sous la forme d'une cavité fermée.

6. Procédé selon la revendication 5, **caractérisé en ce qu'**il comprend une étape f), réalisée après l'étape d) et avant ou après l'étape e), de création d'une ouverture en forme de canal (12) avec une extension latérale à travers ladite deuxième couche (3), établissant un chemin entre ledit interstice (5") et l'extérieur de la structure.

7. Procédé selon la revendication 1, **caractérisé en ce que** du Si est formé en tant que ladite première couche (2) dans l'étape a) et **en ce qu'**une microstructure de SiC cristallin du polytype 3C est produite.

8. Procédé selon l'une quelconque des revendications précédentes, **caractérisé en ce que** la hauteur dudit interstice (5, 5', 5") est définie par la formation de ladite première couche (2) avec une épaisseur de 0,2 à 5 µm, en particulier de 0,5 à 2 µm, dans l'étape a).

9. Procédé selon l'une quelconque des revendications précédentes, **caractérisé en ce que** ladite première couche (2) est formée dans l'étape a) sur un substrat (1) de SiC cristallin qui a précédemment été formé sur une couche (10) de Si cristallin.
